# FASCICULE DE BREVET EUROPEEN

(11) **EP 2 926 362 B1**
(45) Date de publication et mention de la délivrance du brevet: **25.07.2018**
(21) Numéro de dépôt: 13818250.6
(22) Date de dépôt: 25.11.2013
(51) Int. Cl.: H01J 37/32

(54) **IMPLANTEUR IONIQUE POURVU D'UNE PLURALITÉ DE CORPS DE SOURCE PLASMA**
IONENIMPLANTER MIT EINER VIELZAHL VON PLASMAQUELLENKÖRPERN
IONIC IMPLANTER WITH A PLURALITY OF PLASMA SOURCE BODIES

(30) Priorité: 27.11.2012 FR 1203188
(43) Date de publication de la demande: 07.10.2015
(73) Titulaire: Ion Beam Services, 13790 Peynier (FR)
(72) Inventeur: TORREGROSA Frank, 13109 Simiane (FR); ROUX Laurent, 13013 Marseille (FR)
(74) Mandataire: Renaud-Goud, Thierry
(86) Numéro de dépôt international: PCT/FR2013/000308
(87) Numéro de publication internationale: WO 2014/083246

(56) Documents cités:
- EP-A2- 0 403 418
- EP-A2- 0 480 688
- EP-B1- 1 763 891
- US-B1- 6 274 459
- US-B1- 6 300 227

## Description

La présente invention concerne un implanteur ionique pourvu d'une pluralité de corps de source plasma.

Le domaine de l'invention est celui des implanteurs ioniques opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par cm² et de la profondeur d'implantation.

Le plasma est engendré au sein d'un corps de source qui est agencé face au porte-substrat. Ce corps de source se présente comme une section de cylindre dépourvue de tout obstacle à l'intérieur ; il débouche dans l'enceinte de l'implanteur. Autour du corps de source, prend place l'antenne radiofréquence prévue pour générer le plasma. Généralement, le cylindre sur lequel s'appuie le corps de source est un cylindre de révolution.

Le diamètre du corps de source est nécessairement limité car la densité du plasma décroît au fur et à mesure que l'on s'éloigne de l'antenne. Afin de conserver une densité de plasma satisfaisante au centre du corps de source, ce diamètre est donc généralement compris entre 100 et 200 mm.

Le plasma s'étend du corps de source vers le porte-substrat selon un profil hyperboloïde. Il s'ensuit qu'un substrat de grande dimension doit être placé relativement loin du porte-substrat si l'on souhaite que l'implantation se produise sur la totalité de sa surface.

Cet éloignement a pour conséquence que la densité du plasma au niveau du substrat est sensiblement réduite. Il s'ensuit que, pour une dose donnée, la durée d'implantation est sensiblement accrue.

Ainsi, le document EP 0 480 688 enseigne un agencement de sources plasma pour implantation ionique. L'implanteur comporte une enceinte dans laquelle est agencée un porte-substrat connecté à une alimentation substrat par l'intermédiaire d'un passage électrique haute tension, cette enceinte étant pourvue de moyens de pompage, cette enceinte comportant encore un corps de source cylindrique dépourvu de tout obstacle et disposé face au porte-substrat, cette enceinte comportant au moins un corps de source cylindrique additionnel également dépourvu de tout obstacle et disposé lui aussi face au porte-substrat.

On citera également le document US 6,300,227 qui décrit un système pour implantation ionique par immersion plasma analogue à celui mentionné ci-dessus. Le document EP1763891 B1 décrit également un système pour implantation ionique par immersion plasma avec une enceinte ayant un seul corps de source avec une bobine de confinement. Dans un cas comme dans l'autre, un moyen de confinement magnétique est prévu au niveau de l'enceinte. Or cet agencement n'est pas optimal vis-à-vis de l'homogénéité du plasma.

La présente invention a ainsi pour objet un implanteur ionique adapté aux substrats de grandes dimensions, permettant aussi de traiter de nombreux substrats de petites dimensions agencés sur un porte-substrat de grande dimension, cet implanteur offrant une homogénéité du plasma accrue.

Selon l'invention, un implanteur ionique comporte une enceinte dans laquelle est agencée un porte-substrat connecté à une alimentation substrat par l'intermédiaire d'un passage électrique haute tension, cette enceinte étant pourvue de moyens de pompage, cette enceinte comportant encore au moins deux corps de source cylindriques dépourvus de tout obstacle et disposés face au porte-substrat ; l'implanteur ionique est remarquable en ce qu'il comporte au moins une bobine de confinement par corps de source.

Suivant cette configuration, le champ magnétique est maximal à l'endroit de la formation du plasma. Les lignes de champ s'évasent dans l'enceinte, ce qui provoque une extension du plasma, avec pour conséquence une bonne homogénéité sur une surface plus importante au niveau du porte-substrat. De plus, il est ainsi possible d'ajuster le champ magnétique produit par chaque bobine de confinement, ce qui donne un réglage supplémentaire pour améliorer l'homogénéité sur la surface à traiter.

Avantageusement, les corps de source sont chacun pourvus d'une antenne radiofréquence extérieure.

Selon une caractéristique additionnelle de l'invention, l'implanteur ionique comporte un générateur radiofréquence commun pour toutes les antennes.

Suivant un premier mode de réalisation, l'implanteur ionique comporte une boîte d'accord unique agencée entre le générateur radiofréquence et les antennes.

Suivant un deuxième mode de réalisation, l'implanteur ionique comporte, en aval du générateur radiofréquence, une boîte d'accord suivie d'un séparateur.

Suivant un troisième mode de réalisation, l'implanteur ionique comporte, en aval du générateur radiofréquence, un séparateur suivi d'un nombre de boîtes d'accord identique au nombre de corps de source.

La présente invention apparaîtra maintenant avec plus de détails dans le cadre de la description qui suit d'exemples de réalisation donnés à titre illustratif en se référant au dessin joint au sein duquel :
- la figure 1 représente un schéma en coupe verticale d'un implanteur ionique selon l'invention,
- la figure 2 représente un schéma en vue de dessus de cet implanteur,
- la figure 3 représente un premier mode de réalisation de l'alimentation substrat,
- la figure 4 représente un deuxième mode de réalisation de l'alimentation substrat,
- la figure 5 représente un troisième mode de réalisation de l'alimentation substrat,
- la figure 6 représente un diagramme temporel schématisant un procédé d'implantation ionique,
- la figure 7 représente un premier mode de réalisation de l'alimentation des corps de source,
- la figure 8 représente un deuxième mode de réalisation de l'alimentation des corps de source, et
- La figure 9 représente un troisième mode de réalisation de l'alimentation des corps de source.

Les éléments présents sur plusieurs figures sont affectés d'une seule et même référence.

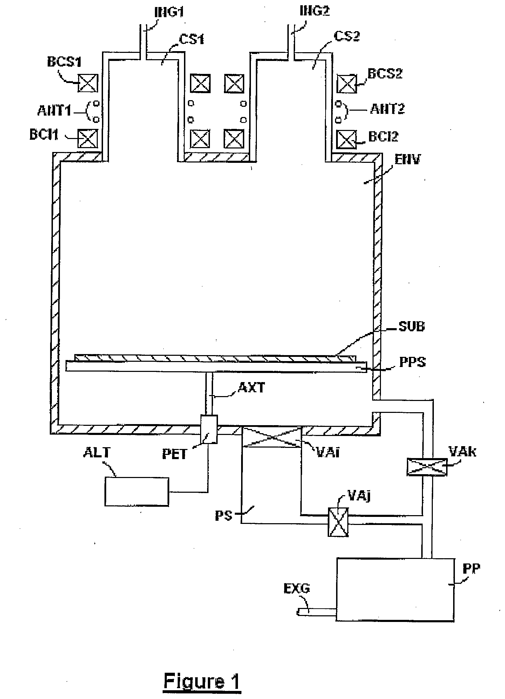

Tel que montré sur la figure 1, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium (ou bien une enceinte en acier inoxydable protégée par des plaques en alliage d'aluminium) si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, éventuellement mobile autour de son axe vertical AXT, reçoit le substrat SUB devant subir l'implantation ionique.

Un passage électrique haute tension PET ménagé dans la partie inférieure de l'enceinte ENV relie électriquement l'axe vertical du plateau AXT, et donc le plateau porte-substrat PPS, à une alimentation substrat ALT.

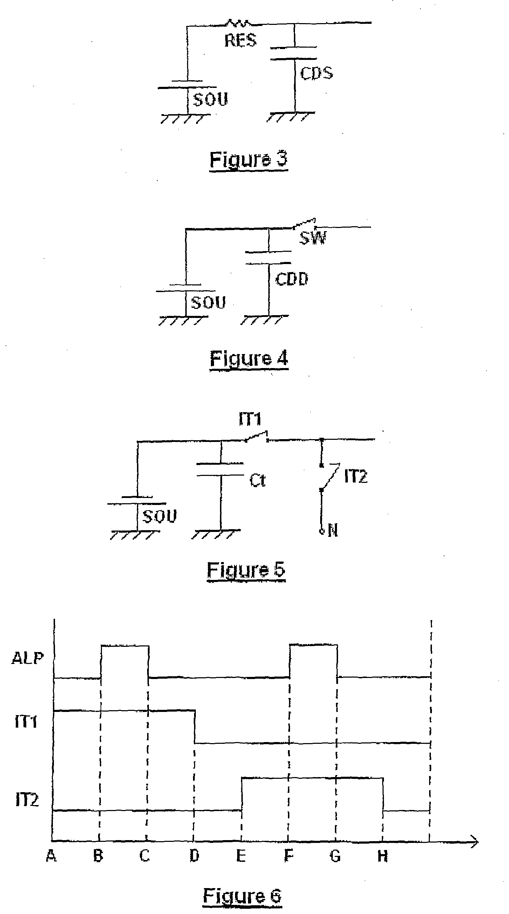

En référence à la figure 3, selon un premier mode de réalisation, cette alimentation substrat ALT comporte un générateur de tension continue SOU dont le pôle positif est raccordé à la masse. Une branche de dérivation qui est montée en parallèle sur ce générateur est formée d'un condensateur CDS et d'une résistance RES en série, cette résistance étant connectée au pôle négatif du générateur SOU. Le plateau porte-substrat PPS est connecté au point commun entre le condensateur CDS et la résistance RES.

Le condensateur CDS présente une capacité de faible valeur afin de faire revenir progressivement le potentiel du substrat à une valeur voisine de zéro lors de sa phase de décharge.

En référence à la figure 4, selon un deuxième mode de réalisation, cette alimentation substrat ALT comporte un générateur de tension continue SOU dont le pôle positif est raccordé à la masse. Un condensateur CDD est monté en parallèle sur ce générateur. Un interrupteur SW est connecté entre le pôle négatif du générateur SOU et le plateau porte-substrat PPS. Cet interrupteur SW est réalisé en technologie « MOS » (pour Metal Oxyde Semiconductor en anglais) ou en technologie « IGBT » (pour Insulated Gate Bipolar Transistor en anglais).

En référence à la figure 5, selon un troisième mode de réalisation analogue à celui décrit dans le document WO 01/15200, cette alimentation substrat ALT comporte :
- un générateur de tension continue SOU dont le pôle positif est raccordé à la masse,
- un condensateur Ct en parallèle sur le générateur GEN,
- un premier interrupteur IT1 dont le premier pôle est raccordé au pôle négatif du générateur GEN et dont le second pôle est raccordé à la sortie de cette alimentation, et
- un deuxième interrupteur IT2 dont le premier pôle est également raccordé à la sortie et dont le second pôle est raccordé à une borne de neutralisation ; cette borne de neutralisation est reliée soit à la masse, soit à une tension légèrement positive (quelques dizaines de Volts) par l'intermédiaire d'une résistance de décharge.

Par ailleurs, des moyens de pompage sont également disposés à la partie inférieure de l'enceinte ENV. Une pompe primaire PP est reliée en entrée à l'enceinte ENV par une conduite munie d'une vanne VAk, et en sortie à l'air libre par une conduite d'échappement EXG. Une pompe secondaire PS est reliée en entrée à l'enceinte ENV par une conduite munie d'une vanne VAi, et en sortie à l'entrée de la pompe primaire PP par une conduite munie d'une vanne VAj. Les conduites ne sont pas référencées.

L'implanteur ionique comporte ici 4 corps de sources identiques dont deux seulement apparaissent sur la figure 1. Un corps de source se présente comme une section de cylindre dont la base débouche dans l'enceinte ENV et dont le sommet est obturé par une plaque. Aucun obstacle ne figure dans ce corps de source de sorte que le plasma puisse s'y propager librement.

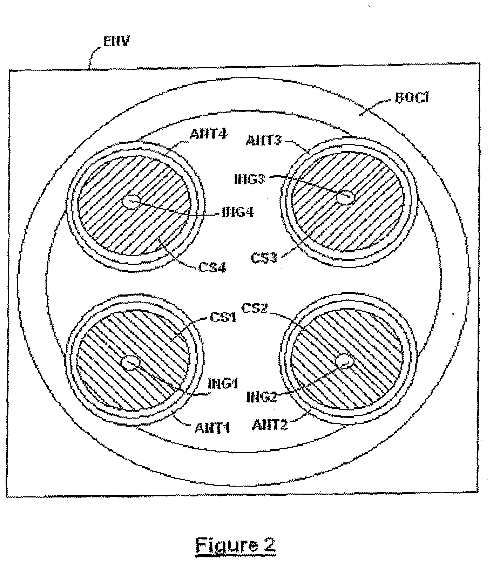

En référence aux figures 1 et 2, la partie supérieure de l'enceinte ENV reçoit donc quatre corps de source plasma CS1, CS2, CS3, CS4 qui font face au porte-substrat PPS. Ces corps sont en quartz. Ils sont extérieurement entourés chacun par une antenne radiofréquence ANT1, ANT2, ANT3, ANT4 située sensiblement en son milieu. Il sont chacun muni d'une entrée de gaz plasmagène ING1, ING2, ING3, ING4 qui est centrée sur la plaque à son sommet.

Avantageusement, les quatre corps de source CS1, CS2, CS3, CS4 sont également entourés par une bobine de confinement magnétique inférieure qui est située entre les antennes ANT1, ANT2, ANT3, ANT4 et l'enceinte ENV. On préfère adopter une bobine par corps de source. Ainsi, sur la figure 1, on voit une première bobine de confinement BCI1 pour le premier corps de source CS1 et une seconde bobine de de confinement BCI2 pour le second corps de source CS2.

De préférence, les quatre corps de source CS1, CS2, CS3, CS4 sont aussi entourés par une bobine de confinement magnétique supérieure BOCs qui est omise sur la figure 2 pour des raisons de clarté. Cette bobine de confinement supérieure est située entre les antennes ANT1, ANT2, ANT3, ANT4 et les sommets des corps de source. Ici encore, on prévoit une première bobine BCS1 pour le premier corps de source CS1 et une seconde bobine pour le second corps de source CS2.

Il est possible d'utiliser tout type de source plasma puisée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte 0ENV à la masse n'allume pas un plasma de décharge qui vienne perturber le fonctionnement pulsé de la source.

Le choix de la source doit permettre d'avoir un potentiel plasma inférieur à 20 Volts. En effet, l'énergie d'accélération des ions est la différence entre le potentiel plasma et le potentiel du substrat. L'énergie d'accélération est alors contrôlée uniquement par la tension appliquée au substrat. Ce point devient prédominant si l'on souhaite des énergies d'accélération très faibles, inférieures à 500 eV, ce qui est le cas pour des applications en microélectronique.

Pour des applications nécessitant un faible niveau de contamination métallique, telles la microélectronique encore une fois et le traitement de pièces dans le domaine médical, la source ne doit pas présenter d'élément métallique contaminant en contact avec le plasma. Dans le mode de réalisation présenté, une source RF formée d'un tube en quartz est associée à une antenne radiofréquence extérieure ANT et à des bobines de confinement magnétique BOCi, BOCs comme précisé précédemment. Alternativement, le corps de source peut être en alumine.

N'importe quelle espèce plasmagène peut être implantée. Il est possible de partir d'un précurseur gazeux tel N₂; O₂, H₂, He, Ar, BF₃, B₂H₆, AsH₃, PH₃, SiH₄, C₂H₄ ; on peut également employer un mélange de gaz tel que B₂H₆+H₂, AsH₃+H₂, PH₃+H₂, etc. Il est aussi possible de partir d'un précurseur liquide tel TiCl₄, H₂O, ou même d'un précurseur solide. Dans ce dernier cas, il convient d'utiliser un système d'évaporation thermique (phosphore) ou un système arc (« hollow cathode » en anglais).

Selon le premier mode de réalisation de l'alimentation substrat décrit en référence à la figure 3, le procédé d'implantation mettant en oeuvre l'implanteur comporte de manière périodique la répétition des quatre ou cinq phases suivantes :
- une phase de charge du condensateur CDS (la source plasma étant éteinte) par le générateur SOU jusqu'à l'obtention d'une tension de décharge,
- une phase d'allumage du plasma qui est initiée lorsque la tension du substrat atteint la tension de décharge : l'impédance du plasma n'étant plus infinie, le condensateur CDS se décharge à travers celui-ci,

- une phase de décharge du condensateur CDS, durant laquelle l'implantation est réalisée et pendant laquelle la gaine du plasma s'étend, et
- une phase d'extinction du plasma qui est initiée lorsque la phase précédente a duré le temps souhaité : l'impédance du plasma est à nouveau infinie et la phase de charge peut être réitérée,
- une éventuelle phase d'attente, durant laquelle rien ne se passe, qui permet d'ajuster la période de répétition.

Lors de la phase de décharge qui dure le temps d'une impulsion plasma, une zone d'extension plasma constituée d'un nuage de gaz ionisé se forme entre les corps de source CS1, CS2, CS3, CS4 et le plateau porte substrat PPS. Les particules viennent heurter le substrat à implanter SUB avec une énergie permettant leur pénétration à l'intérieur du substrat SUB.

Selon le deuxième mode de réalisation de l'alimentation substrat décrit en référence à la figure 4, le procédé d'implantation mettant en oeuvre l'implanteur se déroule comme suit.

Lorsque l'interrupteur SW est ouvert, le condensateur CDD se charge progressivement à la tension nominale du générateur SOU.

Lorsque l'on ferme cet interrupteur SW alors que le plasma est allumé, il s'ensuit un appel du courant dû à la capacité équivalente de la machine et à la capacité de la gaine plasma. La capacité équivalente de la machine est celle de tous les éléments qui la composent, notamment les câbles, les passages électriques, les transformateurs d'isolation et celle qui est formée entre le porte-substrat et l'enceinte.

L'interrupteur SW reste fermé typiquement entre 5 µs et 100 µs, phase pendant laquelle se produit l'implantation car les ions positifs sont attirés vers le substrat qui est polarisé négativement.

Le condensateur présente une forte capacité (typiquement entre 300 nF et 1,5 µF) de sorte que la tension à ses bornes ne chute pas lors de l'implantation.

Après la phase d'implantation, l'interrupteur SW est ouvert et le générateur SOU charge à nouveau le condensateur CDD.

Pendant ce temps, la capacité équivalente de la machine se décharge totalement dans le plasma et le substrat revient à un potentiel flottant. Il s'ensuit que les électrons du plasma viennent neutraliser les zones isolantes du substrat qui se sont chargées positivement au cours de l'implantation.

La phase de neutralisation durant laquelle l'interrupteur SW reste ouvert dure typiquement de 1 µs à 80 µs.

Une fois la phase de neutralisation achevée, le plasma peut être éteint durant une phase d'extinction, ce qui présente l'avantage de réduire les interactions plasma/surface, de réduire le budget thermique et de minimiser la création de particules. Cette phase d'extinction dure typiquement de 20 µs à 200 µs, phase pendant laquelle l'interrupteur SW reste ouvert.

Il est alors possible de répéter le cycle décrit ci-dessus :
- phase d'implantation,
- phase de neutralisation,
- phase d'extinction.

En référence à la figure 6, selon le troisième mode de réalisation de l'alimentation substrat décrit en référence à la figure 5, le procédé d'implantation mettant en oeuvre l'implanteur se présente comme suit.

Etat initial :
- alimentation plasma ALP inactivée,
- premier interrupteur IT1 ouvert,
- deuxième interrupteur IT2 ouvert.

Au début d'un cycle, prend place la phase d'implantation qui débute par une étape d'initialisation représentée par le point A sur la figure 6.

Cette étape d'initialisation commence par la fermeture du premier interrupteur IT1. Elle s'étend sur une période de stabilisation qui vaut typiquement entre 1 µs et 5 µs.

A la suite de cette étape d'initialisation, vient une phase d'activation (point B sur la figure 6), étape durant laquelle l'alimentation plasma ALP est activée. La durée de cette étape d'activation s'étend typiquement entre 5 µs et 100 µs.

Vient ensuite une étape d'extinction (point C sur la figure 6) au début de laquelle l'alimentation plasma ALP est inactivée. Cette étape durant laquelle le plasma s'éteint dure typiquement de 20 µs à 200 µs. Elle met fin à la phase d'implantation.

Une étape de pause (point D sur la figure 6) commence par l'ouverture du premier interrupteur IT1 et se termine au début de la phase de neutralisation. Elle peut être relativement courte mais elle doit durer tant que le premier interrupteur IT1 n'est pas totalement ouvert et tant que le plasma n'est pas totalement éteint. Sa durée est donc supérieure à 0,1 µs et vaut typiquement entre 1 et 10 µs.

La phase de neutralisation commence avec une étape préliminaire (point E sur la figure 6) au début de laquelle le deuxième interrupteur SW2 est fermé. Cette étape préliminaire dure tant que la tension du plateau porte-substrat n'est pas revenue à la tension appliquée sur la borne de neutralisation N. Sa durée est typiquement comprise entre 1 µs et 40 µs.

Vient ensuite une étape d'annulation (point F sur la figure 6) durant laquelle l'alimentation plasma ALP est activée. Les électrons du plasma sont attirés vers les zones du substrat qui sont chargés positivement et viennent neutraliser la charge. La durée de cette étape d'annulation est typiquement comprise entre 1 µs et 80 µs.

Vient ensuite une étape d'inactivation (point G sur la figure 6) au début de laquelle l'alimentation plasma est désactivée. La durée de cette étape vaut typiquement quelques dizaines de µs.

Le cycle se termine avec une étape d'interruption (point H sur la figure 6) qui commence avec l'ouverture du second interrupteur SW2. Cette étape d'interruption dure tant que ce second interrupteur n'est pas totalement ouvert et tant que le plasma n'est pas totalement éteint pour revenir à l'état initial.

Alors, un nouveau cycle peut être initié.

Il apparaît ainsi que la phase de relaxation (entre les points C et F sur la figure 6) durant laquelle l'alimentation plasma ALP est inactivée chevauche la phase d'implantation et la phase de neutralisation.

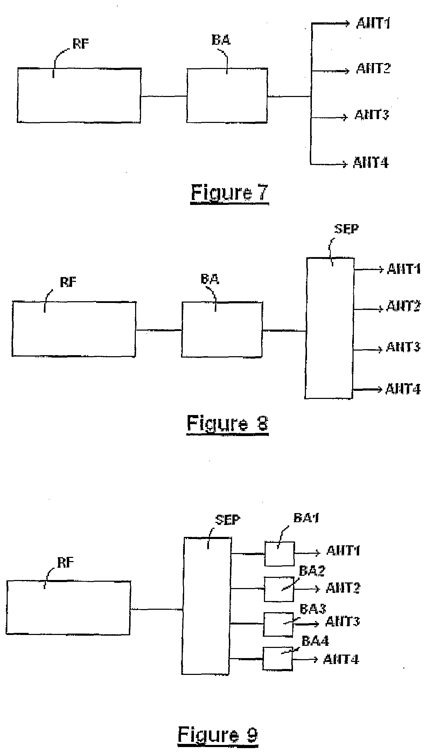

En référence à la figure 7, on présente un premier mode de réalisation de l'alimentation plasma ALP des corps de source CS1, CS2, CS3, CS4. Un générateur radiofréquence RF est suivi d'une boîte d'accord BA qui alimente les quatre antennes ANT1, ANT2, ANT3, ANT4. Ce mode de réalisation a le mérite de la simplicité et il est peu coûteux. Cependant, il nécessite un très bon équilibrage du plasma au niveau de chaque corps de source.

En référence à la figure 8, suivant un deuxième mode de réalisation, on améliore cette situation. Le générateur radiofréquence RF est toujours suivie d'une boîte d'accord BA mais celle-ci est maintenant raccordée à un séparateur SEP quatre voies dont chacune des voies est raccordée à une antenne ANT1, ANT2, ANT3, ANT4, Ici, on peut partager la puissance de sorte qu'elle soit égale pour chacun des corps de source CS1, CS2, CS3, CS4. Il peut toutefois s'avérer difficile de trouver l'accord, notamment lors des phases d'allumage du plasma.

En référence à la figure 9, suivant un troisième mode de réalisation, on améliore cette situation. Maintenant, le générateur radiofréquence RF est suivi du séparateur SEP quatre voies. La première voie attaque une première boîte d'accord BA1 qui alimente la première antenne ANT1. La deuxième voie attaque une deuxième boîte d'accord BA2 qui alimente la deuxième antenne ANT2. La troisième voie attaque une troisième boîte d'accord BA3 qui alimente la troisième antenne ANT3. Finalement, la quatrième voie attaque une quatrième boîte d'accord BA4 qui alimente la quatrième antenne ANT4.

Naturellement, la solution optimale quant aux réglages possibles consiste à prévoir une alimentation et une boîte d'accord pour chaque corps de source CS1, CS2, CS3, CS4 mais cette solution est onéreuse et le matériel requis est encombrant. Par ailleurs, il est nécessaire de synchroniser les différentes alimentations.

Les exemples de réalisation de l'invention présentés ci-dessus ont été choisi eu égard à leur caractère concret. Il ne serait cependant pas possible de répertorier de manière exhaustive tous les modes de réalisation que recouvre cette invention. L'invention est telle que définie dans les revendications annexées.

## Revendications

1. Implanteur ionique comportant une enceinte (ENV) dans laquelle est agencé un porte-substrat (PPS) connecté à une alimentation substrat (ALT) par l'intermédiaire d'un passage électrique haute tension (PET), cette enceinte étant pourvue de moyens de pompage (PP, PS), **caractérisé en ce qu'**il comporte encore au moins deux corps de source (CS1, CS2, CS3, CS4) cylindriques dépourvus de tout obstacle et disposés face audit porte-substrat (PPS), et comportant au moins une bobine de confinement (BC11-BCS1, BC12-BCS2) par corps de source (CS1, CS2, CS3, CS4).

2. Implanteur ionique selon la revendication 1, **caractérisé en ce que** lesdits corps de source (CS1, CS2, CS3, CS4) sont chacun pourvus d'une antenne radiofréquence (ANT1, ANT2, ANT3, ANT4) extérieure.

3. Implanteur ionique selon l'une quelconque des revendications 1 ou 2, **caractérisé en ce qu'**il comporte un générateur radiofréquence (RF) commun pour toutes lesdites antennes (ANT1, ANT2, ANT3, ANT4).

4. Implanteur ionique selon la revendication 3, **caractérisé en ce qu'**il comporte une boîte d'accord (BA) unique agencée entre ledit générateur radiofréquence (RF) et lesdites antennes (ANT1, ANT2, ANT3, ANT4).

5. Implanteur ionique selon la revendication 3, **caractérisé en ce qu'**il comporte, en aval dudit générateur radiofréquence (RF), une boîte d'accord (BA) suivie d'un séparateur (SEP).

6. Implanteur ionique selon la revendication 3, **caractérisé en ce qu'**il comporte, en aval dudit générateur radiofréquence (RF), un séparateur (SEP) suivi d'un nombre de boîtes d'accord (BA1, BA2, BA3, BA4) identique au nombre de corps de source (CS1, CS2, CS3, CS4).

## Patentansprüche

1. Ionenimplanter, der ein Gehäuse (ENV) aufweist, in dem ein Substratträger (PPS) angeordnet ist, der mit einer Substratversorgung (ALT) über einen elektrischen Hochspannungsdurchgang (PET) verbunden ist, wobei dieses Gehäuse (ENV) mit Pumpeinrichtungen (PP, PS) versehen ist, **dadurch gekennzeichnet, dass** er noch mindestens zwei zylindrische Quellenkörper (CS1, CS2, CS3, CS4) ohne jedes Hindernis und gegenüber dem Substratträger (PPS) angeordnet aufweist, und mindestens eine Einschluss-Spule (BCI1-BCI2, BCI2-BCS2) pro Quellenkörper (CS1, CS2, CS3, CS4) aufweist.

2. Ionenimplanter nach Anspruch 1, **dadurch gekennzeichnet, dass** die Quellenkörper (CS1, CS2, CS3, CS4) je mit einer äußeren Hochfrequenzantenne (ANT1, ANT2, ANT3, ANT4) versehen sind.

3. Ionenimplanter nach einem der Ansprüche 1 oder 2, **dadurch gekennzeichnet, dass** er einen gemeinsamen Hochfrequenzgenerator (RF) für alle Antennen (ANT1, ANT2, ANT3, ANT4) aufweist.

4. Ionenimplanter nach Anspruch 3, **dadurch gekennzeichnet, dass** er ein einziges Abstimmgerät (BA) aufweist, das zwischen dem Hochfrequenzgenerator (RF) und den Antennen (ANT1, ANT2, ANT3, ANT4) angeordnet ist.

5. Ionenimplanter nach Anspruch 3, **dadurch gekennzeichnet, dass** er stromabwärts hinter dem Hochfrequenzgenerator (RF) ein Abstimmgerät (BA) gefolgt von einem Separator (SEP) aufweist.

6. Ionenimplanter nach Anspruch 3, **dadurch gekennzeichnet, dass** er stromabwärts hinter dem Hochfrequenzgenerator (RF) einen Separator (SEP) gefolgt von einer Anzahl von Abstimmgeräten (BA1, BA2, BA3, BA4) gleich der Anzahl von Quellenkörpern (CS1, CS2, CS3, CS4) aufweist.

## Claims

1. An ion implanter comprising an enclosure (ENV) having arranged therein a substrate carrier (PPS) connected to a substrate power supply (ALT) via a high voltage electrical passage (PET), the enclosure (ENV) being provided with pump means (PP, PS), the ion implanter being **characterized in that** it also has at least two cylindrical source bodies (CS1, CS2, CS3, CS4) free from any obstacle and arranged facing said substrate carrier (PPS); and including at least one confinement coil (BCI1-BCS1, BCI2-BCS2) per source body (CS1, CS2, CS3, CS4) .

2. An ion implanter according to claim 1, **characterized in that** each of said source bodies (CS1, CS2, CS3, CS4) is provided with an external radiofrequency antenna (ANT1, ANT2, ANT3, ANT4).

3. An ion implanter according to claim 1 or claim 2, **characterized in that** it includes a common radiofrequency generator (RF) for all of said antennas (ANT1, ANT2, ANT3, ANT4).

4. An ion implanter according to claim 3, **characterized in that** it includes a single tuning box (BA) arranged between said radiofrequency generator (RF) and said antennas (ANT1, ANT2, ANT3, ANT4).

5. An ion implanter according to claim 3, **characterized in that** it includes, downstream from said radiofrequency generator (RF), a tuning box (BA) followed by a separator (SEP).

6. An ion implanter according to claim 3, **characterized in that** it includes, downstream from said radiofrequency generator (RF), a separator (SEP) followed by a number of tuning boxes (BA1, BA2, BA3, BA4) identical to the number of source bodies (CS1, CS2, CS3, CS4).
